# EUROPÄISCHE PATENTSCHRIFT

(11) **EP 3 701 608 B1**
(45) Veröffentlichungstag und Bekanntmachung des Hinweises auf die Patenterteilung: **11.10.2023**
(21) Anmeldenummer: 17794693.6
(22) Anmeldetag: 23.10.2017
(51) Int. Cl.: H02H 3/08, H02H 7/08, H03K 17/0812, G01R 31/327, H03K 17/082, G01R 31/40, H02H 7/22, H03K 17/08

(54) **SCHUTZSCHALTUNG FÜR EINEN FELD-EFFEKT-TRANSISTOR**
PROTECTIVE CIRCUIT FOR A FIELD-EFFECT TRANSISTOR
CIRCUIT DE PROTECTION D'UN TRANSISTOR À EFFET DE CHAMP

(43) Veröffentlichungstag der Anmeldung: 02.09.2020
(73) Patentinhaber: GKN Automotive Ltd., West Midlands, B37 7YE (GB)
(72) Erfinder: LIEBSCH, Roman, 51503 Rösrath (DE)
(74) Vertreter: karo IP
(86) Internationale Anmeldenummer: PCT/EP2017/076970
(87) Internationale Veröffentlichungsnummer: WO 2019/080989

(56) Entgegenhaltungen:
- DE-A1-102012 109 745
- US-A- 5 959 464
- US-B2- 7 589 490

## Beschreibung

Die vorliegende Erfindung betrifft eine Schutzschaltung für einen ersten Feld-Effekt-Transistor, wobei die Schutzschaltung insbesondere in einem Kraftfahrzeug eingesetzt wird. Ein Feld-Effekt-Transistor umfasst einen Source-Anschluss, einen Drain-Anschluss sowie einen Gate-Anschluss. Über den Gate-Anschluss kann eine elektrisch leitende Verbindung zwischen Source-Anschluss und Drain-Anschluss ein- und ausgeschaltet werden.

Einige Schaltungen mit Feld-Effekt-Transistoren (sogenannte FETs) zur Ansteuerung von Pumpen, Stellmotoren oder anderen Aggregaten sind bereits bekannt. Aus der US 7,759, 891 B2 ist bekannt, dass in einer solchen Schaltung eine Temperaturüberwachung eines FETs vorgesehen ist. Die Temperaturüberwachung soll einen über den FET angesteuerten Motor vor Beschädigungen schützen. Es wird davon ausgegangen, dass eine Überschreitung eines Grenzwerts der Temperatur z. B. im Fall eines elektrischen Kurzschlusses auftritt. Daher wird die Temperatur des FETs mit einer Umgebungstemperatur verglichen und, sobald die so ermittelte Differenztemperatur den festgelegten Grenzwert überschreitet, eine Stromweiterleitung über den FET abgeschaltet. Eine differenziertere Auswertung der Ursache für das Erreichen des Grenzwertes ist hierbei nicht möglich.

Aus der DE 10 2012 109 745 A1 ist eine Schaltungsanordnung mit einer Brückenschaltung umfassend zwei FETs bekannt. Die Schaltungsanordnung wird für den Betrieb eines elektrischen Motors vorgeschlagen.

Aus der US 7,589,490 B2 ist ein Motor-Kontrollsystem bekannt. Dabei wird aus einer Temperaturmessung an einem FET ein Widerstand des FET ermittelt und basierend auf einem bekannten Spannungsabfall ein dem Motor zugeführter Strom errechnet.

Die US 5,959,464 ist auf eine Schaltung mit Transistor zur Bereitstellung eines Stroms von einer Spannungsquelle an einen Verbraucher gerichtet. Dabei wird aus einer bekannten Spannung und einem, aus einer ermittelten Temperatur des Transistors bestimmten Widerstand der über den Transistor geleitete Strom bestimmt.

Aufgabe der Erfindung ist es daher, die mit Bezug auf den Stand der Technik vorhandenen Probleme zumindest teilweise zu lösen und insbesondere eine Schutzschaltung bereitzustellen, durch die eine genaue Auswertung der über einen Feld-Effekt-Transistor geleiteten elektrischen Ströme möglich ist. Dabei soll eine möglichst kostengünstige Schutzschaltung bereitgestellt werden.

Diese Aufgaben werden gelöst mit einer Schutzschaltung bzw. einem Verfahren gemäß den Merkmalen der Patentansprüche 1 und 6. Weitere vorteilhafte Ausgestaltungen der Schutzschaltung und der Erfindung sind in den weiteren Patentansprüchen angegeben. Darüber hinaus werden die in den Patentansprüchen angegebenen Merkmale in der Beschreibung näher präzisiert und erläutert, wobei weitere bevorzugte Ausgestaltungen der Erfindung dargestellt werden.

Hierzu trägt eine Schutzschaltung bei, die zumindest einen ersten Feld-Effekt-Transistor, ein Steuergerät sowie einen ersten Temperatursensor umfasst. Der erste Feld-Effekt-Transistor weist einen ersten Source-Anschluss, einen ersten Drain-Anschluss und einen ersten Gate-Anschluss auf. Mit dem Steuergerät ist eine elektrische erste Spannung [Volt] zwischen dem ersten Source-Anschluss und dem ersten Drain-Anschluss ermittelbar. Mit dem ersten Temperatursensor ist eine sich ändernde erste Temperatur [Grad Celsius] des ersten Feld-Effekt-Transistors erfassbar. Mit dem Steuergerät ist anhand der ersten Temperatur ein erster (elektrischer) Widerstand [Ohm] des ersten Feld-Effekt-Transistors und (damit) ein über den ersten Feld-Effekt-Transistor geleiteter elektrischer erster Strom (Stromstärke in [Ampere]) ermittelbar.

Es wird hier insbesondere vorgeschlagen, die (aktuelle) erste Temperatur des ersten Feld-Effekt-Transistors sensorisch und/oder rechnerisch zu ermitteln. Diese wird aber insbesondere nicht mit einer Umgebungstemperatur verglichen. Hier wird insbesondere ausschließlich die erste Temperatur ermittelt und damit auf einen sich in Abhängigkeit von der ersten Temperatur ändernden ersten Widerstand des ersten Feld-Effekt-Transistors geschlossen. In Kenntnis der über den ersten Feld-Effekt-Transistor abfallenden ersten Spannung und des ersten Widerstands ist dann ein über den ersten Feld-Effekt-Transistor geleiteter elektrischer erster Strom (insbesondere rechnerisch) ermittelbar.

Dafür ist eine Charakteristik des ersten Feld-Effekt-Transistors, also eine Veränderung des ersten elektrischen Widerstands in Abhängigkeit von einer ersten Temperatur des ersten Feld-Effekt-Transistors, bekannt und im Steuergerät hinterlegt.

Insbesondere kann hier ein (zumindest im Arbeitsbereich annährend) linearer Zusammenhang zwischen erster Temperatur und erstem Widerstand vordefiniert sein. Dieser lineare Zusammenhang liegt bevorzugt zumindest in einem Bereich des ersten Widerstands vor, in dem sich der Betrag des ersten Widerstands zwischen 50 % und 200 % eines Mittelwerts des ersten Widerstands verändert. Der Mittelwert des ersten Widerstands liegt bei einer vorgegebenen Referenztemperatur der ersten Temperatur vor, z. B. bei 20 Grad Celsius.

Der erste Feld-Effekt-Transistor ist über den ersten Drain-Anschluss mit einer Spannungsquelle verbunden, wobei zwischen der Spannungsquelle und dem ersten Feld-Effekt-Transistor ein zweiter Feld-Effekt-Transistor angeordnet ist. Der zweite Feld-Effekt-Transistor weist einen zweiten Source-Anschluss, einen zweiten Drain-Anschluss und einen zweiten Gate-Anschluss auf. Mittels des Steuergeräts ist eine elektrische zweite Spannung zwischen dem zweiten Source-Anschluss und dem zweiten Drain-Anschluss ermittelbar. Durch den zweiten Temperatursensor ist eine sich ändernde zweite Temperatur des zweiten Feld-Effekt-Transistors (sensorisch) erfassbar. Anhand der zweiten Temperatur ist ein zweiter elektrischer Widerstand des zweiten Feld-Effekt-Transistors und (damit) ein über den zweiten Feld-Effekt-Transistor geleiteter elektrischer zweiter Strom ermittelbar (wie vorstehend für den ersten Feld-Effekt-Transistor beschrieben).

Die Spannungsquelle stellt insbesondere eine Spannung von höchstens 100 Volt bereit, insbesondere 12 Volt, 24 Volt oder 48 Volt.

Der erste Source-Anschluss ist mit zumindest einer elektrischen Maschine und über die elektrische Maschine mit einer elektrischen Masse verbindbar.

Zwischen der elektrischen Maschine und der Masse ist ein dritter Feld-Effekt-Transistor angeordnet, wobei zwischen dem dritten Feld-Effekt-Transistor und der Masse ein elektrischer Messwiderstand zur Ermittlung eines über den dritten Feld-Effekt-Transistor geleiteten elektrischen dritten Stroms angeordnet ist.

Der Messwiderstand (auch als Shunt bezeichnet) ist insbesondere ein niederohmiger elektrischer Widerstand, der (ggf. im Wesentlichen nur) zur Messung der elektrischen Stromstärke verwendet wird. Der Strom, der durch einen Shunt fließt, verursacht einen zu seiner Stärke proportionalen Spannungsabfall, der gemessen wird.

Der Messwiderstand ist mit dem Steuergerät elektrisch leitend verbunden, so dass ein über den dritten Feld-Effekt-Transistor geleiteter Strom mit dem Steuergerät überwacht werden kann.

Die Anordnung eines solchen Messwiderstands bzw. eines zusätzlichen Messwiderstands in der Schaltung bzw. Schutzschaltung (also im Bereich des ersten und zweiten Feld-Effekt-Transistors) ist kostspielig. Hier wird also vorgeschlagen, zumindest in Ergänzung zu dem einen Messwiderstand (und/oder als Ersatz für den Messwiderstand) zumindest einen Temperatursensor zur Erfassung einer Änderung des Widerstands eines Feld-Effekt-Transistors vorzusehen, so dass anhand der Änderung des Widerstands auf den durch den Feld-Effekt-Transistor geleiteten elektrischen Strom geschlossen werden kann.

Die elektrische Maschine kann eine Nennleistung [Watt] von weniger als 10 Kilowatt, insbesondere von weniger als 5 Kilowatt, bevorzugt von weniger als 1 Kilowatt, aufweisen.

Zumindest der erste elektrische Strom (und/oder der zweite Strom) kann über die sich ändernde erste Temperatur (bzw. zweite Temperatur) mit einer Genauigkeit von weniger als 2,0 Ampere, insbesondere weniger als 1,5 Ampere, bevorzugt weniger als 1,0 Ampere, bestimmbar sein.

Zumindest der erste Temperatursensor (und/oder der zweite Temperatursensor) kann über einen Analog-Digital-Wandler mit dem Steuergerät verbunden sein. Über den Analog-Digital-Wandler können analoge Signale eines Temperatursensors in digitale Signale umgewandelt werden. Die Umwandlung kann mit einer geforderten Auflösung erfolgen, so dass ein elektrischer Strom mit einer geforderten oder benötigten Genauigkeit ermittelbar ist.

Es wird ein Kraftfahrzeug mit einer elektrischen Maschine und mit einer vorstehend beschriebenen Schutzschaltung vorgeschlagen, wobei der erste Source-Anschluss des ersten Feld-Effekt-Transistors mit zumindest der elektrischen Maschine und über die elektrische Maschine mit einer elektrischen Masse verbunden ist.

Die Ausführungen zu der Schutzschaltung können einzeln und in Kombination miteinander zur Erläuterung für das Kraftfahrzeug herangezogen werden und umgekehrt.

Es wird zudem ein Verfahren zum Betrieb bzw. Schutz einer elektrischen Schaltung vorgeschlagen, wobei die elektrische Schaltung zumindest eine vorstehend beschriebene Schutzschaltung aufweist. Das Verfahren weist zumindest die folgenden Schritte auf:
a) Ermitteln einer elektrischen ersten Spannung zwischen dem ersten Source-Anschluss und dem ersten Drain-Anschluss;
b) Erfassen einer ersten Temperatur des ersten Feld-Effekt-Transistors;
c) Berechnen eines über den ersten Feld-Effekt-Transistor geleiteten elektrischen ersten Stroms (mit dem Steuergerät).

Der erste Source-Anschluss ist mit zumindest einer elektrischen Maschine und über die elektrische Maschine mit einer elektrischen Masse verbunden, wobei zwischen der elektrischen Maschine und der elektrischen Masse ein dritter Feld-Effekt-Transistor angeordnet ist. Zwischen dem dritten Feld-Effekt-Transistor und der elektrischen Masse ist ein Messwiderstand zur Ermittlung eines über den dritten Feld-Effekt-Transistor geleiteten elektrischen dritten Stroms angeordnet sein. In einem Prozess i) wird der dritte Strom ermittelt, wobei in einem Prozess ii) in dem Steuergerät eine Auswertung des ersten Stroms und des dritten Stroms (und/oder des zweiten Stroms) erfolgt.

Durch die Auswertung der einzelnen elektrischen Ströme kann auf einen Zustand der Schutzschaltung geschlossen werden. Insbesondere sind so Kurzschlüsse erkennbar und bewertbar. Anhand der Auswertung kann eine Entscheidung getroffen werden, ob ein Betrieb der Schutzschaltung fortgesetzt werden kann, ob eine Warnmeldung abgesetzt werden soll oder ob der Betrieb der Schutzschaltung zumindest zeitweise unterbrochen oder eingeschränkt fortgeführt werden soll. In dem Steuergerät sind Grenzwerte hinterlegt, so dass bei Erreichen bestimmter Grenzwerte bestimmte Maßnahmen eingeleitet werden können.

Die Ausführungen zu dem Verfahren können einzeln und in Kombination miteinander zur Erläuterung für die Schutzschaltung und/oder das Kraftfahrzeug herangezogen werden und umgekehrt.

Vorsorglich sei angemerkt, dass die hier verwendeten Zahlwörter ("erste", "zweite", "dritte",...) vorrangig (nur) zur Unterscheidung von mehreren gleichartigen Gegenständen, Größen oder Prozessen dienen, also insbesondere keine Abhängigkeit und/oder Reihenfolge dieser Gegenstände, Größen oder Prozesse zueinander zwingend vorgeben. Sollte eine Abhängigkeit und/oder Reihenfolge erforderlich sein, ist dies hier explizit angegeben oder es ergibt sich offensichtlich für den Fachmann beim Studium der konkret beschriebenen Ausgestaltung.

Die Erfindung sowie das technische Umfeld werden nachfolgend anhand der schematischen Figur näher erläutert. Es ist darauf hinzuweisen, dass die Erfindung durch das gezeigte Ausführungsbeispiel nicht beschränkt werden soll, sondern durch den Gegenstand der unabhängigen Patentansprüche definiert ist.

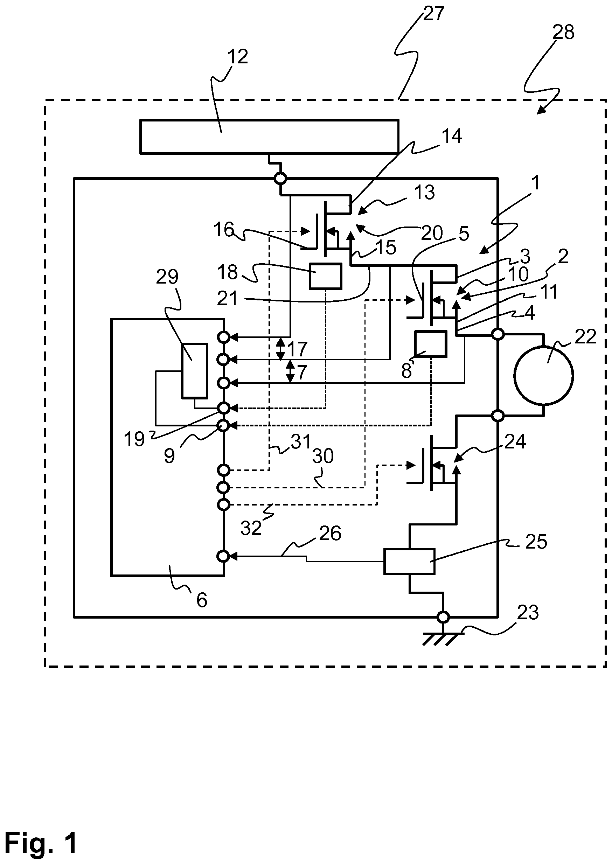

Fig. 1 zeigt ein Kraftfahrzeug 27 mit einer elektrischen Schaltung 28, die eine Schutzschaltung 1 umfasst. Die elektrische Schaltung 28 umfasst eine Spannungsquelle 12, eine elektrische Maschine 22 und eine Masse 23. Ein Steuergerät 6 regelt und überwacht den Betrieb der elektrischen Maschine 22 über die Schaltung 28. Die Schutzschaltung 1 für den ersten Feld-Effekt-Transistor 2 umfasst den ersten Feld-Effekt-Transistor 2, ein Steuergerät 6 sowie einen ersten Temperatursensor 8. Der erste Feld-Effekt-Transistor 2 weist einen ersten Drain-Anschluss 3, einen ersten Source-Anschluss 4 und einen ersten Gate-Anschluss 5 auf. Mit dem Steuergerät 6 ist eine elektrische erste Spannung 7 zwischen dem ersten Drain-Anschluss 3 und dem ersten Source-Anschluss 4 ermittelbar. Mit dem ersten Temperatursensor 8 ist eine sich ändernde erste Temperatur 9 des ersten Feld-Effekt-Transistors 2 erfassbar. Mit dem Steuergerät 6 ist anhand der ersten Temperatur 9 ein erster Widerstand 10 des ersten Feld-Effekt-Transistors 2 und damit ein über den ersten Feld-Effekt-Transistor 2 geleiteter elektrischer erster Strom 11 ermittelbar.

Hier wird ausschließlich die erste Temperatur 9 ermittelt und damit auf einen sich in Abhängigkeit von der ersten Temperatur 9 ändernden ersten Widerstand 10 des ersten Feld-Effekt-Transistors 2 geschlossen. In Kenntnis der über den ersten Feld-Effekt-Transistor 2 abfallenden ersten Spannung 7 und des ersten Widerstands 10 ist ein über den ersten Feld-Effekt-Transistor 2 geleiteter elektrischer erster Strom 11 ermittelbar.

Der erste Feld-Effekt-Transistor 2 ist über den ersten Drain-Anschluss 3 mit der Spannungsquelle 12 verbunden, wobei zwischen der Spannungsquelle 12 und dem ersten Feld-Effekt-Transistor 2 ein zweiter Feld-Effekt-Transistor 13 angeordnet ist. Der zweite Feld-Effekt-Transistor 13 weist einen zweiten Drain-Anschluss 14, einen zweiten Source-Anschluss 15 und einen zweiten Gate-Anschluss 16 auf. Durch das Steuergerät 6 ist eine elektrische zweite Spannung 17 zwischen dem zweiten Drain-Anschluss 14 und dem zweiten Source-Anschluss 15 ermittelbar. Durch einen zweiten Temperatursensor 18 ist eine sich ändernde zweite Temperatur 19 des zweiten Feld-Effekt-Transistors 13 erfassbar. Anhand der zweiten Temperatur 19 ist ein zweiter Widerstand 20 des zweiten Feld-Effekt-Transistors 13 und damit ein über den zweiten Feld-Effekt-Transistor 13 geleiteter elektrischer zweiter Strom 21 ermittelbar.

Zwischen der elektrischen Maschine 22 und der Masse 23 ist ein dritter Feld-Effekt-Transistor 24 angeordnet, wobei zwischen dem dritten Feld-Effekt-Transistor 24 und der Masse 23 ein Messwiderstand 25 zur Ermittlung eines über den dritten Feld-Effekt-Transistor 24 geleiteten elektrischen dritten Stroms 26 angeordnet ist.

Der Messwiderstand 25 ist mit dem Steuergerät 6 verbunden, so dass ein über den dritten Feld-Effekt-Transistor 24 geleiteter dritter Strom 26 mit dem Steuergerät 6 überwacht werden kann.

Der erste Temperatursensor 8 und der zweite Temperatursensor 18 sind über einen Analog-Digital-Wandler 29 mit dem Steuergerät 6 verbunden. Über den Analog-Digital-Wandler 29 können analoge Signale der Temperatursensoren 8, 18 in digitale Signale umgewandelt werden. Die Umwandlung kann mit einer geforderten Auflösung erfolgen, so dass ein elektrischer Strom 11, 21 mit einer geforderten oder benötigten Genauigkeit ermittelbar ist. Über den Analog-Digital-Wandler 29 können auch die elektrischen Spannungen 7, 17 erfasst und insbesondere in digitale Signale umgewandelt werden.

Durch die Auswertung der einzelnen elektrischen Ströme 11, 21, 26 kann auf einen Zustand der Schutzschaltung 1 bzw. der Schaltung 28 geschlossen werden. Insbesondere sind so Kurzschlüsse erkennbar und bewertbar. Anhand der Auswertung kann eine Entscheidung getroffen werden, ob ein Betrieb der Schutzschaltung 1 bzw. der Schaltung 28 fortgesetzt werden kann, ob eine Warnmeldung abgesetzt werden soll oder ob der Betrieb der Schutzschaltung 1/Schaltung 28 zumindest zeitweise unterbrochen oder eingeschränkt fortgeführt werden soll.

Im Steuergerät 6 sind Grenzwerte für Verhältnisse von Strömen 11, 21, 26 etc. hinterlegt, so dass bei Erreichen bestimmter Grenzwerte bestimmte Maßnahmen eingeleitet werden können. Es können Grenzwerte für Ströme 11, 21, 26 im Steuergerät hinterlegt werden.

Durch das Steuergerät 6 können Steuersignale 30, 31, 32 an die Gate-Anschlüsse 5, 16 der Feld-Effekt-Transistoren 2, 13, 24 übermittelt und eine dementsprechende Schaltung der Feld-Effekt-Transistoren 2, 13, 24 vorgenommen werden.

### Bezugszeichenliste

- 1: Schutzschaltung
- 2: erster Feld-Effekt-Transistor
- 3: erster Drain-Anschluss
- 4: erster Source-Anschluss
- 5: erster Gate-Anschluss
- 6: Steuergerät
- 7: erste Spannung
- 8: erster Temperatursensor
- 9: erste Temperatur
- 10: erster Widerstand
- 11: erster Strom
- 12: Spannungsquelle
- 13: zweiter Feld-Effekt-Transistor
- 14: zweiter Drain-Anschluss
- 15: zweiter Source-Anschluss
- 16: zweiter Gate-Anschluss
- 17: zweite Spannung
- 18: zweiter Temperatursensor
- 19: zweite Temperatur
- 20: zweiter Widerstand
- 21: zweiter Strom
- 22: elektrische Maschine
- 23: Masse
- 24: dritter Feld-Effekt-Transistor
- 25: Messwiderstand
- 26: dritter Strom
- 27: Kraftfahrzeug
- 28: Schaltung
- 29: Analog-Digital-Wandler
- 30: erstes Steuersignal
- 31: zweites Steuersignal
- 32: drittes Steuersignal

## Patentansprüche

1. Schutzschaltung (1) für einen ersten Feld-Effekt-Transistor (2), zumindest umfassend den ersten Feld-Effekt-Transistor (2), ein Steuergerät (6), einen ersten Temperatursensor (8), einen zweiten Feld-Effekt-Transistor (13), einen dritten Feld-Effekt-Transistor (24), einen zweiten Temperatursensor (18) sowie ein Messwiderstand (25), wobei der erste Feld-Effekt-Transistor (2) einen ersten Drain-Anschluss (3), einen ersten Source-Anschluss (4) und einen ersten Gate-Anschluss (5) aufweist, wobei durch das Steuergerät (6) eine elektrische erste Spannung (7) zwischen dem ersten Drain-Anschluss (3) und dem ersten Source-Anschluss (4) ermittelbar und in dem Steuergerät (6) eine Charakteristik des ersten Feld-Effekt-Transistors (2), also eine Veränderung eines ersten elektrischen Widerstands (10) in Abhängigkeit von einer ersten Temperatur (9) des ersten Feld-Effekt-Transistors (2) hinterlegt ist, wobei durch den ersten Temperatursensor (8) die sich ändernde erste Temperatur (9) des ersten Feld-Effekt-Transistors (2) erfassbar ist; wobei mit dem Steuergerät (6) anhand der ersten Temperatur (9) der erste Widerstand (10) des ersten Feld-Effekt-Transistors (2) und ein über den ersten Feld-Effekt-Transistor (2) geleiteter elektrischer erster Strom (11) ermittelbar ist; wobei der erste Source-Anschluss (4) mit einer elektrischen Maschine (22) und über die elektrische Maschine (22) mit einer elektrischen Masse (23) verbindbar ist; wobei zwischen der elektrischen Maschine (22) und der elektrischen Masse (23) der dritte Feld-Effekt-Transistor (24) angeordnet ist, **dadurch gekennzeichnet, dass** der erste Feld-Effekt-Transistor (2) über den ersten Drain-Anschluss (3) mit einer Spannungsquelle (12) verbindbar ist; wobei zwischen der Spannungsquelle (12) und dem ersten Feld-Effekt-Transistor (2) der zweite Feld-Effekt-Transistor (13) angeordnet ist, der einen zweiten Drain-Anschluss (14), einen zweiten Source-Anschluss (15) und einen zweiten Gate-Anschluss (16) aufweist; wobei durch das Steuergerät (6) eine elektrische zweite Spannung (17) zwischen dem zweiten Drain-Anschluss (14) und dem zweiten Source-Anschluss (15) ermittelbar ist; wobei weiter durch den zweiten Temperatursensor (18) eine sich ändernde zweite Temperatur (19) des zweiten Feld-Effekt-Transistors (13) erfassbar ist; wobei anhand der zweiten Temperatur (19) ein zweiter Widerstand (20) des zweiten Feld-Effekt-Transistors (13) und ein über den zweiten Feld-Effekt-Transistor (13) geleiteter elektrischer zweiter Strom (21) ermittelbar ist; wobei zwischen dem dritten Feld-Effekt-Transistor (24) und der elektrischen Masse (23) der Messwiderstand (25) zur Ermittlung eines über den dritten Feld-Effekt-Transistors (24) geleiteten elektrischen dritten Stroms (26) angeordnet ist; wobei der Messwiderstand (25) mit dem Steuergerät (6) elektrisch leitend verbunden ist, wobei das Steuergerät (6) eingerichtet ist, den dritten Strom (26) zu überwachen; wobei in dem Steuergerät (6) Grenzwerte für Verhältnisse der ermittelten Ströme (11, 21, 26) hinterlegt sind und das Steuergerät (6) eingerichtet ist, bei Erreichen bestimmter Grenzwerte Steuersignale (30, 31, 32) an die Gate-Anschlüsse (5, 16) der Feld-Effekt-Transistoren (2, 13, 24) zu übermitteln, um eine dementsprechende Schaltung der Feld-Effekt-Transistoren (2, 13, 24) vorzunehmen.

2. Schutzschaltung (1) nach Patentanspruch 1, wobei die elektrische Maschine (22) eine Nennleistung von weniger als 10 Kilowatt aufweist.

3. Schutzschaltung (1) nach einem der vorhergehenden Patentansprüche, wobei zumindest der erste Strom (11) über die sich ändernde erste Temperatur (9) mit einer Genauigkeit von weniger als 2,0 Ampere bestimmbar ist.

4. Schutzschaltung (1) nach einem der vorhergehenden Patentansprüche, wobei zumindest der erste Temperatursensor (8) über einen Analog-Digital-Wandler (29) mit dem Steuergerät (6) verbunden ist.

5. Kraftfahrzeug (27) mit der elektrischen Maschine (22), der elektrischen Masse (23), der Spannungsquelle (12) sowie einer Schutzschaltung (1) nach einem der vorhergehenden Patentansprüche; wobei der erste Drain-Anschluss (4) des ersten Feld-Effekt-Transistors (2) mit zumindest der elektrischen Maschine (22) und über die elektrische Maschine (22) mit der elektrischen Masse (23) verbunden ist.

6. Verfahren zum Betrieb einer elektrischen Schaltung (28), die zumindest eine Schutzschaltung (1) nach einem der vorhergehenden Patentansprüche 1 bis 4 aufweist; zumindest aufweisend die folgenden Schritte:
a) Ermitteln einer elektrischen ersten Spannung (7) zwischen dem ersten Drain-Anschluss (3) und dem ersten Source-Anschluss (4);
b) Erfassen einer ersten Temperatur (9) des ersten Feld-Effekt-Transistors (2);
c) Ermitteln eines ersten Widerstands (10) des ersten Feld-Effekt-Transistors (2) anhand der ersten Temperatur (9) und Berechnen eines über den ersten Feld-Effekt-Transistor (2) geleiteten elektrischen ersten Stroms (11);
wobei der erste Source-Anschluss (4) mit der elektrischen Maschine (22) und über die elektrische Maschine (22) mit der Masse (23) verbunden ist; wobei zwischen der elektrischen Maschine (22) und der Masse (23) der dritte Feld-Effekt-Transistor (24) angeordnet ist, **dadurch gekennzeichnet, dass** zwischen dem dritten Feld-Effekt-Transistor (24) und der Masse (23) der Messwiderstand (25) zur Ermittlung eines über den dritten Feld-Effekt-Transistor (24) geleiteten elektrischen dritten Stroms (26) angeordnet ist; wobei in einem Schritt i) der dritte Strom (26) ermittelt wird und in einem Schritt ii) in dem Steuergerät (6) eine Auswertung des ersten Stroms (11), des zweiten Stroms (21) und des dritten Stroms (26) erfolgt; wobei in dem Steuergerät (6) Grenzwerte für Verhältnisse der ermittelten Ströme (11, 21, 26) hinterlegt sind und durch das Steuergerät (6), bei Erreichen bestimmter Grenzwerte Steuersignale (30, 31, 32) an die Gate-Anschlüsse (5, 16) der Feld-Effekt-Transistoren (2, 13, 24) übermittelt und eine dementsprechende Schaltung der Feld-Effekt-Transistoren (2, 13, 24) vorgenommen werden.

## Claims

1. Protective circuit (1) for a first field-effect transistor (2), at least comprising the first field-effect transistor (2), a control device (6), a first temperature sensor (8), a second field-effect transistor (13), a third field-effect transistor (24), a second temperature sensor (18), and a measuring resistor (25), wherein first field-effect transistor (2) has a first drain terminal (3), a first source terminal (4) and a first gate terminal (5), wherein by means of the control device (6) an electrical first voltage (7) between the first drain terminal (3) and the first source terminal (4) is determinable and a characteristic of the first field-effect transistor (2), that is to say a variation of the first electrical resistance (10) as a function of a first temperature (9) of the first field-effect transistor (2), is stored in the control device (6), wherein by means of the first temperature sensor (8) the changing first temperature (9) of the first field-effect transistor (2) is detectable; wherein the first resistance (10) of the first field-effect transistor (2) and an electrical first current (11) conducted via the first field-effect transistor (2) are determinable by the control device (6); wherein the first source terminal (4) is connected to a electrical machine (22) and to a ground (23) via the electrical machine (22); wherein the third field-effect transistor (24) is arranged between the electrical machine (22) and the ground (23), **characterized in that** the first field-effect transistor (2) is connectable to a voltage source (12) via the first drain terminal (3), wherein the second field-effect transistor (13) is arranged between the voltage source (12) and the first field-effect transistor (2) which has a second drain terminal (14), a second source terminal (15) and a second gate terminal (16); wherein an electrical second voltage (17) between the second drain terminal (14) and the second source terminal (15) is determinable by means of the control device (6); wherein a changing second temperature (19) of the second field-effect transistor (13) is furthermore detectable by means of the second temperature sensor (18); wherein a second resistance (20) of the second field-effect transistor (13) and an electrical second current (21) conducted via the second field-effect transistor (13) are determinable on the basis of the second temperature (19); wherein the measuring resistor (25) for determining an electrical third current (26) conducted via the third field-effect transistor (24) is arranged between the third field-effect transistor (24) and the ground (23); wherein the measuring resistor (25) is electrically connected with the control device (6), wherein the control device (6) is set up to monitor the third current (26); wherein limit values for ratios of determined currents (11, 21, 26) are stored in the control device (6), wherein the control device (6) is set up to communicate control signals (30, 31, 32) to the gate terminals (5, 16) of the field-effect transistors (2, 13, 24) once specific limit values are reached, so that corresponding switching of the field-effect transistors (2, 13, 24) can be performed.

2. Protective circuit (1) as claimed in claim 1, wherein the electrical machine (22) has a rated power of less than 10 kilowatts.

3. Protective circuit (1) as claimed in any of the preceding claims, wherein at least the first current (11) is ascertainable with an accuracy of less than 2.0 amperes by way of the changing first temperature (9).

4. Protective circuit (1) as claimed in any of the preceding claims, wherein at least the first temperature sensor (8) is connected to the control device (6) via an analog-to-digital convertor (29).

5. Motor vehicle (27) comprising the electrical machine (22), the ground (23), the voltage source (12), and the protective circuit (1) as claimed in any of the preceding claims; wherein the first drain terminal (4) of the first field-effect transistor (2) is connected to at least the electrical machine (22) and to the electrical ground (23) via the electrical machine (22).

6. Method for operating an electrical circuit (28) comprising at least one protective circuit (1) as claimed in any of the preceding claims 1 to 4; at least comprising the following steps:
a) determining an electrical first voltage (7) between the first drain terminal (3) and the first source terminal (4);
b) detecting a first temperature (9) of the first field-effect transistor (2);
c) calculating an electrical first current (11) conducted via the first field-effect transistor (2) based on the first temperature (9) and calculating an electrical first current (11) conducted via the first field-effect transistor (2);
wherein the first source terminal (4) is connected to the electrical machine (22) and to a ground (23) via the electrical machine (22); wherein the third field-effect transistor (24) is arranged between the electrical machine (22) and the ground (23), **characterized in that** the measuring resistor (25) for determining an electrical third current (26) conducted via the third field-effect transistor (24) is arranged between the third field-effect transistor (24) and the ground (23); wherein in a step i) the third current (26) is determined and in a step ii) the first current (11) and the third current (26) are evaluated in the control device (6); wherein limit values for ratios of the determined currents (11, 21, 26) are stored in the control device (6) and by means of the control device (6), once specific limit values are reached, control signals (30, 31, 32) are communicated to the gate terminals (5, 16) of the field-effect transistors (2, 13, 24) and corresponding switching of the field-effect transistors (2, 13, 24) is performed.

## Revendications

1. Circuit de protection (1) pour un premier transistor à effet de champ (2), comprenant au moins le premier transistor à effet de champ (2), un contrôleur (6), une première sonde de température (8), un deuxième transistor à effet de champ (13), un troisième transistor à effet de champ (24), une deuxième sonde de température (18) ainsi qu'une résistance de mesure (25), le premier transistor à effet de champ (2) possédant une première borne de drain (3), une première borne de source (4) et une première borne de gâchette (5), une première tension électrique (7) entre la première borne de drain (3) et la première borne de source (4) pouvant être déterminée par le contrôleur (6) et une caractéristique du premier transistor à effet de champ (2), c'est-à-dire une modification d'une première résistance électrique (10) en fonction d'une première température (9) du premier transistor à effet de champ (2), étant stockée dans le contrôleur (6), la première température (9) qui varie du premier transistor (8) à effet de champ (2) pouvant être acquise par le contrôleur (6) ; la première résistance (10) du premier transistor à effet de champ (2) ainsi qu'un premier courant électrique (11) conduit par le biais du premier transistor à effet de champ (2) pouvant être déterminés par le contrôleur (6) à l'aide de la première température (9) ; la première borne de source (4) pouvant être reliée à une machine électrique (22) et, par le biais de la machine électrique (22), à une masse électrique (23) ; le troisième transistor à effet de champ (24) étant disposé entre la machine électrique (22) et la masse électrique (23), **caractérisé en ce que** le premier transistor à effet de champ (2) peut être relié à une source de tension (12) par le biais de la première borne de drain (3) ; le deuxième transistor à effet de champ (13) étant disposé entre la source de tension (12) et le premier transistor à effet de champ (2), lequel possède une deuxième borne de drain (14), une deuxième borne de source (15) et une deuxième borne de gâchette (16) ; une deuxième tension électrique (17) entre la deuxième borne de drain (14) et la deuxième borne de source (15) pouvant être déterminée par le contrôleur (6) ; une deuxième température (19) qui varie du deuxième transistor à effet de champ (13) pouvant en outre être acquise par la deuxième sonde de température (18) ; une deuxième résistance (20) du deuxième transistor à effet de champ (13) ainsi qu'un deuxième courant électrique (21) conduit par le biais du deuxième transistor à effet de champ (13) pouvant être déterminés à l'aide de la deuxième température (19) ; la résistance de mesure (25) destinée à déterminer un troisième courant électrique (26) conduit par le biais du troisième transistor à effet de champ (24) étant disposée entre le troisième transistor à effet de champ (24) et la masse électrique (23) ; la résistance de mesure (25) étant reliée de manière électriquement conductrice au contrôleur (6), le contrôleur (6) étant conçu pour surveiller le troisième courant (26) ; des valeurs limites pour les rapports des courants (11, 21, 26) déterminés étant stockées dans le contrôleur (6) et le contrôleur (6) étant conçu pour, lorsque certaines valeurs limites sont atteintes, transmettre des signaux de commande (30, 31, 32) aux bornes de gâchette (5, 16) des transistors à effet de champ (2, 13, 24) afin d'effectuer une commutation correspondante des transistors à effet de champ (2, 13, 24).

2. Circuit de protection (1) selon la revendication 1, la machine électrique (22) présentant une puissance nominale inférieure à 10 kilowatts.

3. Circuit de protection (1) selon l'une des revendications précédentes, au moins le premier courant (11) pouvant être déterminé par le biais de la première température (9) qui varie avec une précision de moins de 2,0 ampères.

4. Circuit de protection (1) selon l'une des revendications précédentes, au moins la première sonde de température (8) étant reliée au contrôleur (6) par le biais d'un convertisseur analogique-numérique (29).

5. Véhicule à moteur (27) comprenant la machine électrique (22), la masse électrique (23), la source de tension (12) ainsi qu'un circuit de protection (1) selon l'une des revendications précédentes ; la première borne de drain (4) du premier transistor à effet de champ (2) étant relié au moins à la machine électrique (22) et, par le biais de la machine électrique (22), à la masse électrique (23).

6. Procédé pour faire fonctionner un circuit électrique (28), lequel possède au moins un circuit de protection (1) selon l'une des revendications précédentes 1 à 4 ; comprenant au moins les étapes suivantes :
a) détermination d'une première tension électrique (7) entre la première borne de drain (3) et la première borne de source (4) ;
b) acquisition d'une première température (9) du premier transistor à effet de champ (2) ;
c) détermination d'une première résistance (10) du premier transistor à effet de champ (2) à l'aide de la première température (9) et calcul d'un premier courant électrique (11) conduit par le biais du premier transistor à effet de champ (2) ;
la première borne de source (4) étant reliée à la machine électrique (22) et, par le biais de la machine électrique (22), à la masse (23) ; le troisième transistor à effet de champ (24) étant disposé entre la machine électrique (22) et la masse (23), **caractérisé en ce que** la résistance de mesure (25) destinée à déterminer un troisième courant électrique (26) conduit par le biais du troisième transistor à effet de champ (24) est disposée entre le troisième transistor à effet de champ (24) et la masse (23) ; le troisième courant (26) étant déterminé dans une étape i) et une interprétation du premier courant (11), du deuxième courant (21) et du troisième courant (26) s'effectuant dans le contrôleur (6) à une étape ii) ; des valeurs limites pour les rapports des courants (11, 21, 26) déterminés étant stockées dans le contrôleur (6) et, lorsque certaines valeurs limites sont atteintes, des signaux de commande (30, 31, 32) étant transmis par le contrôleur (6) aux bornes de gâchette (5, 16) des transistors à effet de champ (2, 13, 24) afin d'effectuer une commutation correspondante des transistors à effet de champ (2, 13, 24).
